Europäisches Patentamt

European Patent Office

Office européen des brevets

(11) Publication number: **0 368 382**
**A1**

## EUROPEAN PATENT APPLICATION

(21) Application number: 89202703.8

(22) Date of filing: 25.10.89

(51) Int. Cl.⁵: **F25B 21/02, H05K 5/02**

(30) Priority: 26.10.88 NL 8802637

(43) Date of publication of application:
16.05.90 Bulletin 90/20

(84) Designated Contracting States:
BE CH DE ES FR GB GR IT LI NL SE

(71) Applicant: HOLEC SYSTEMEN &
COMPONENTEN B.V.
Tuindorpstraat 61
NL-7555 CS Hengelo(NL)

(72) Inventor: Van Dijl, Gerrit
Van Kinsbergenstraat 14
NL-4782 BR Haaksbergen(NL)

(74) Representative: de Bruijn, Leendert C. et al
Nederlandsch Octrooibureau
Scheveningseweg 82 P.O. Box 29720
NL-2502 LS 's-Gravenhage(NL)

(54) **Atmospheric humidity-lowering apparatus for electrical installation boxes and the like.**

(57) Atmospheric humidity-lowering apparatus for a box or casing for corrosion- and/or moisture-sensitive equipment, comprising a heat pump constituted by a Peltier element (3), to be mounted in the casing and having upon current flowing through the Peltier element (3) a cold surface (4), such that moisture present in the casing condenses exclusively thereon and in that means (5, 7, 10) are provided for removing the moisture condensed on the cold surface (4) to the exterior of the casing. The Peltier element (3) being mounted adjacent an outer wall or lid (6) of the casing, wherein the cold surface (4) is situated within the casing and the hot surface is in heat contact with an outer surface (1).

Fig-4

Atmospheric humidity-lowering apparatus for electrical installation boxes and the like.

The invention relates to an atmospheric humidity-lowering apparatus for installation boxes, in particular for a casing in which corrosion- and/or moisture-sensitive equipment is located, comprising a heat pump constituted by a Peltier element, to be mounted at a suitable side in the casing and having upon current flowing through the Peltier element a cold surface, such that moisture present in the casing condenses exclusively thereon and in that means are provided for removing the moisture condensed on the cold surface to the exterior of the casing.

The formation of condensation has already long been a problem in installation boxes, switch casings and the like. Frequently the equipment installed in such boxes and casings is valuable switching, control and/or regulating equipment the functioning of which is adversely influenced by the corrosive action of moisture. This applies in particular in the case of the connecting contacts of electronic semiconductor components on, for example, printed circuit boards. Particularly in the case of boxes installed in the open air, special measures have to be taken in connection with the widely varying weather conditions to counter the adverse consequences of moisture as far as possible.

The most simple solution is to ventilate the interior space of such boxes as well as possible and to remove any water of condensation formed.

However, this simple approach has the disadvantage that dust and the like can also penetrate inside the box. Moreover, ventilation is not really sufficient in the case of a high atmospheric humidity of the outside air and can even itself signify an additional disadvantage. In order additionally to counter soiling of the interior space with this arrangement, filters are also frequently used in combination with a fan. As a result, however, this solution becomes relatively expensive, while it will still function inadequately in the case of a high atmospheric humidity. At the same time, the additional energy consumption and the susceptibility of the fan in terms of maintenance constitute a disadvantage.

Another possibility for tackling the problem is to use heating elements to bring air in the interior space to a temperature such that this will always remain above the dew point temperature and, thus, as little condensation as possible will form. In addition to the disadvantage that this requires extra energy, it is also found that the temperature of components which have a high heat capacity, such as, for example, copper rails, lags behind, as a result of which condensation can again form on these components. Furthermore, it will not always be possible to remain above the dew point temperature. In view of the efforts which are currently directed towards, on the one hand, as high a fill factor as possible, or optimization of the space required, and on the other hand towards an increase in the capacity per unit space, any rise in temperature of the interior space will have an adverse effect and thus should be avoided as far as possible.

An apparatus as described in the introduction is known from US Patent 4,586,342. In this known apparatus the Peltier element, having a cold surface and hot surface, is mounted in a plastic housing, which itself is situated completely within a casing, such as a switch casing. The hot surface is connected with a heat transferring pipe to cooling elements, located at the outside of the switch casing. The housing bottom comprises openings for removing moisture dripping from the cold surface.

The present invention provides a less complicated construction for mounting the Peltier element and is characterized in that the Peltier element is mounted adjacent an outer wall of the casing, the cold surface being situated within the casing and the hot surface being in heat contact with an outer surface, and in that the lower side of the cold surface comprises means for discharging condensed moisture to the exterior of the casing, without affecting the sealing measures which prevent elements from outside to penetrate the casing.

Preferably this wall of the casing is formed by a detachable side wall or lid, having a transverse circumferential rim and flanges connected herewith for mounting the lid on an open casing sidewall. The rim can be of such width that the Peltier element is situated completely within this detachable sidewall, such that moisture dripping from the cold surface is collected on the lower rim. This lower rim preferably comprises small openings for discharging the moisture.

The present invention also comprises an electrical circuit for a Peltier element used in an apparatus as above, in which the Peltier element is controlled by a clock circuit, periodically reversing the polarity of the voltage supplied to the Peltier element, so that the cold surface is heated periodically for defrosting the cold surface.

The invention will now be explained in more detail with the aid of the accompanying drawings, which show schematically the installation of a thermo-electric heat pump in the form of a Peltier element, fitted in the wall of a casing.

Figure 1 shows a side view of a section of a casing wall in which a Peltier element is incorporated.

Figure 2 shows an interior view hereof.

Figure 3 shows the dew point temperature plotted as a function of the ambient temperature and the relative humidity.

Figure 4 shows a cross-section of a detachable casing sidewall and mounted thereon a Peltier element according to the present invention.

Figure 5 shows an electrical control circuit for the Peltier element according to the present invention.

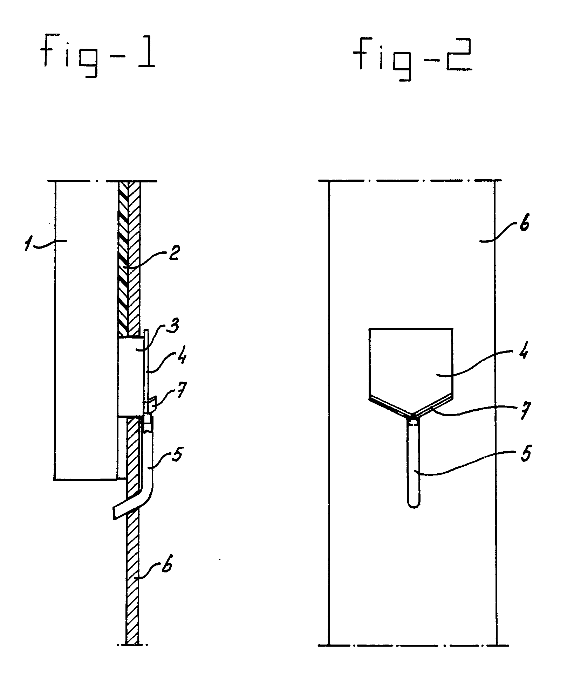

In Figure 1 the Peltier element 3 is mounted in an opening in the casing wall 6 and provided with a condensation surface 4 on the cool side facing towards the inside of the casing. This condensation surface 4 is preferably designed such that condensation water forming thereon can simply be collected and removed. With this arrangement a funnel-shaped channel 7, in which the condensed moisture is collected, is fitted to the underside of the condensation surface 4 of the Peltier element and this channel 7 opens into a discharge tube 5 which is passed through the wall 6 to the outside.

The warm side of the Peltier element 3, which in this example is on the outside of the casing, is in heat contact with a cooling body 1. This can, for example, be fitted with cooling fins. A layer 2 of thermal insulation can be fitted between this cooling body 1 and the casing wall 6 to achieve a better effect. The temperature difference between the cold side and the warm side of the Peltier element 3 is also increased by means of this insulation layer 2. The warm side of the Peltier element can, however, also be mounted against a thermally conducting casing wall 6, which then serves as a heat removal element.

Instead of being mounted on the outside of the casing, the cooling body 1, i.e. the warm side, can also be mounted more inside the casing. This has the advantage that the cooling body can also serve as an assembly plate for components which are located inside the casing and for which it can be desirable that they are at a higher temperature. This can advantageously be used if the casing is installed in a very cold environment.

The dimensions of the cooling body 1 are dependent on the desired temperature difference between the warm and the cold side of the Peltier element and on external conditions, such as outside temperature, positioning inside or outside the casing, etc. If appropriate, a heat-conducting wall of the casing can be used as the warm side.

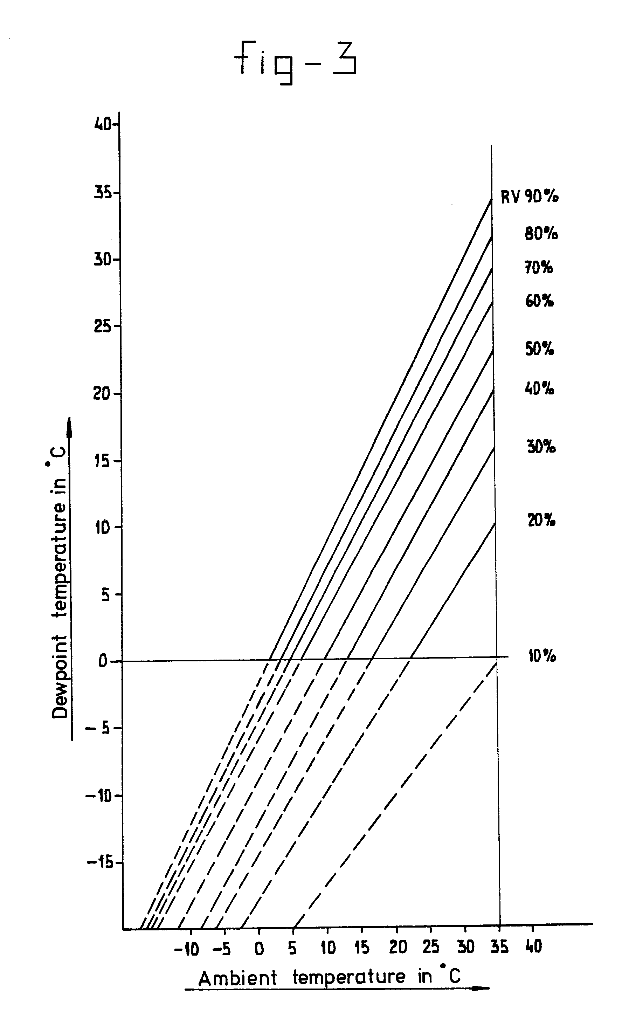

This temperature difference must, of course, be such that the dew point temperature in the casing first occurs on the cold side of the Peltier element at every combination of temperature/atmospheric humidity. As the graph in Figure 3 indicates, the difference between dew point temperature and ambient temperature is approximately 1.25° K for an atmospheric humidity of, for example, 90% and an ambient temperature of 20° C, and about 7.5° K for an atmospheric humidity of 60% and the same ambient temperature. Theoretically, a temperature difference of about 2° K between the cold side of the Peltier element and the ambient temperature will thus be sufficient to be able to operate effectively.

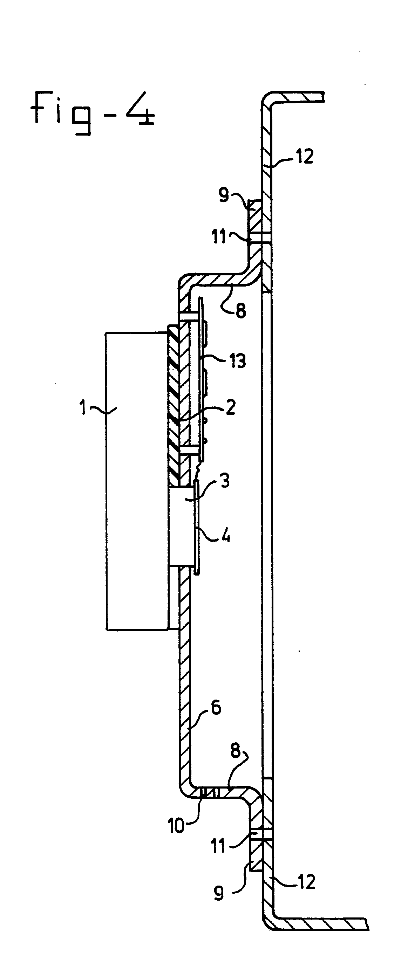

Figure 4 shows a cross-section of a detachable casing sidewall, mounted thereon a Peltier element according to the present invention. This casing sidewall or lid comprises a transverse wall rim 8 and flange wall parts 9. These flange wall parts 9 serve to mount this side wall or lid on an open side wall 12 of a casing (not shown), by means of screws passing through openings 9.

The Peltier element is of similar construction as in Figures and 2, common parts of which being indicated by the same reference numbers. However, there is no funnel-shaped channel 7 and no discharge tube 5. Instead the moisture collected on the condensation or cold surface 4 here drops on the lower transverse wall rim 8, having openings 10, through which the moisture can be discharged to the casing exterior. These openings are of such size that no dust, dirt, splash water, etc. can penetrate from the outside into the interior of the casing. In these openings caps can be placed, having narrow specially shaped passages preventing in particular splash water to penetrate from the outside.

Above the Peltier element 3 a schematically shown printed circuit board 13 and a supply transformer (not shown) can be mounted on the inner surface of the lid wall 6 for controlling the Peltier element 3.

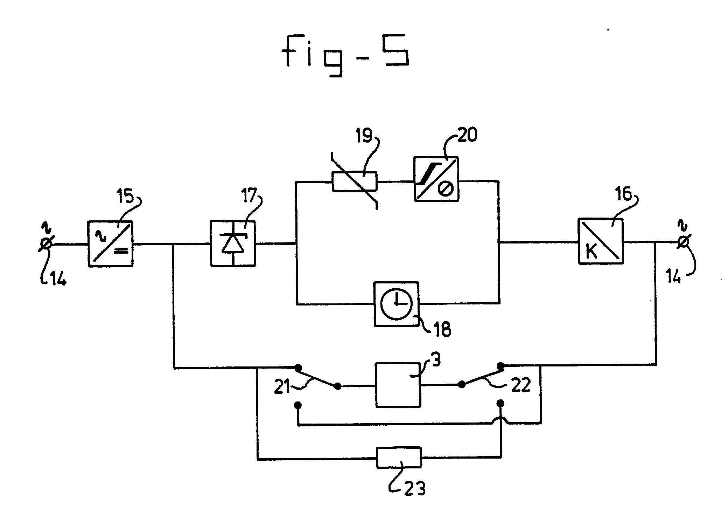

Figure 5 shows an example of such an electrical control circuit. The electrical supply terminals 14 are connected here to an 8 Volt secondary winding of a transformer. The supplied alternating current is rectified in a rectifier 15 and through a voltage stabilizing Zener diode 17 supplied to the controlling part of the circuit. This controlling part comprises a switch clock 18, connected in parallel with a NTC resistor 19 and a temperature sensitive circuit 20. Connected in series herewith is a relay 16.

This relay 16 acts on contact sets 21 and 22 in the lower, controlled part of the circuit, further comprising the Peltier element 3 and a resistor 23. This Peltier element 3 is controlled by the switch clock 18 and by NTC resistor 19 and temperature sensitive circuit 20. The switch clock 18 by means of relay 16 and contact sets 21 and 22, reverse the voltage polarity, supplied to the Peltier element according to a particular frequency pattern, for instance 3 hours positive, in which the Peltier element has a condensation or cold surface 4, and 3 minutes negative, in which the surface 4 is heated to melt ice if present on the cold surface 4. During this negative period the cold surface 4 of the Peltier element also is heated by resistor 23 in order to assist defrosting this surface 4.

By means of temperature sensitive circuit 20 and NTC resistor 19 the switch clock 18 will be short-circuited as soon as the inner temperature within the casing rises above a certain temperature, for instance 20°C. Then the Peltier element is switched on continuously in the positive way to collect moisture on cold surface 4. At this temperature of 20°C no ice will be formed on the cold surface 4, so that it is not necessary to reverse polarity to defrost the cold surface 4 and it could be even disadvantageously to do so.

In order to prevent possible temperature lags and the like, a temperature difference of about 5°K is a good mean to guarantee correct functioning. Of course, the temperature on the cold side can fall so far that ice forms on this side. However, this is not problematic because the same objective is then achieved via the so-called dry freezing effect.

## Claims

1. Atmospheric humidity-lowering apparatus for a box or casing for corrosion- and/or moisture-sensitive equipment, comprising a heat pump constituted by a Peltier element, to be mounted at a suitable side in the casing and having upon current flowing through the Peltier element a cold surface, such that moisture present in the casing condenses exclusively thereon and in that means are provided for removing the moisture condensed on the cold surface to the exterior of the casing, characterized in that the Peltier element is mounted adjacent an outer wall of the casing, the cold surface being situated within the casing and the hot surface being in heat contact with an outer surface, and in that the lower side of the cold surface comprises means for discharging condensed moisture to the exterior of the casing, without affecting the sealing measures which prevent elements from outside to penetrate the casing.

2. Apparatus as claimed in Claim 1, characterized in that said outer sidewall is a removable lid, comprising a large sidewall main surface, a circumferential rim connected to and extending transversely to this main surface and flanges, connected to the rim and extending in the plane of the main surface, for connection to the casing, the lower part of said transverse rim receiving and discharging the moisture dripped from the cold surface through openings in the rim.

3. Apparatus as claimed in Claims 1 or 2, characterized in that the cold surface is situated outside the plane of said casing sidewall or lid.

4. Apparatus as claimed in Claims 1 or 2, characterized in that the cold surface mainly coincides with the plane of said casing sidewall or lid.

5. Apparatus as claimed in Claim 1, characterized in that the warm surface serves as an assembly surface for the components located in the casing, or is connected in a thermally conducting manner to this assembly surface.

6. Apparatus as claimed in one of Claims 1-5, characterized in that the warm side of the Peltier element is in heat contact with a cooling body which is located outside the casing.

7. Apparatus according to claim 6, characterized in that the Peltier element is separated from the casing wall by means of a thermally insulating layer.

8. Apparatus according to Claim 7, characterized in that the insulating layer is located between the cooling body and the casing wall.

9. Apparatus according to one of the preceding claims, characterized in that the warm side of the Peltier element is in heat contact with a thermally conducting casing wall.

10. Electrical control circuit for a Peltier element for use in an apparatus of one of Claims 1-9, characterized by a switch clock circuit, periodically reversing the voltage polarity on or current directions through the Peltier element, such that said cold surface is periodically heated to defrost ice formed on that cold surface.

11. Control circuit as claimed in Claim 10, characterized by a temperature sensitive device for switching off the defrost period as soon as the temperature within the casing reaches a predetermined high temperature.

12. Control circuit as claimed in Claims 10 or 11, characterized in that the temperature sensitive device comprises a NTC resistor.

13. Control circuit as claimed in Claim 10, characterized by a resistor, which during the defrost period is connected in series with the Peltier element by the switch clock circuit to heat the Peltier element.

14. Control clock circuit as claimed in one of Claims 10-13, characterized in that the defrost heat period for removing ice has a duration of mainly 3 minutes and the cold period for condensing moisture on the cold surface has a duration of mainly 3 hours.

# fig-1

# fig-2

# fig-3

Fig-4

# fig-5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US-A-4 499 736 (LIEU)<br>* Column 2, line 36 - column 5, line 2; figures 1-3 * | 1 | F 25 B 21/02<br>H 05 K 5/02 |
| A | | 2,5,9 | |
| | --- | | |
| Y | US-A-3 213 630 (MOLE)<br>* Column 5, line 49 - column 6, line 26; figure 5 * | 1 | |
| | --- | | |
| D,A | US-A-4 586 342 (MORISHITA)<br>* Column 2, line 36 - column 5, line 65; figures 1-10 * | 1,3,6-8 | |
| | --- | | |
| A | US-A-4 764 193 (CLAWSON)<br>* Column 2, line 55 - column 5, line 20; figures 1-4 * | 1,3,9,10 | |
| | --- | | |
| A | US-A-3 180 100 (NEWTON)<br>* Column 1, line 72 - column 3, line 29; figures 1,2 * | 1,4,10 | |
| | --- | | TECHNICAL FIELDS SEARCHED (Int. Cl.5) |
| A | US-A-4 259 843 (KAUSCH)<br>* Column 2, line 19 - column 7, line 8; figures 1-4 * | 2,3 | F 25 B<br>F 24 F<br>H 05 K |
| | --- | | |
| A | US-A-2 984 077 (GASKILL)<br>* Column 1, line 41 - column 2, line 13; figure * | 5 | |
| | --- | | |
| A | US-A-4 400 948 (MOOREHEAD)<br>* Column 2, line 28 - column 4, line 10; figures 1,2 * | 10,14 | |
| | --- | | |
| A | US-A-3 367 124 (BECK)<br>* Column 2, line 20 - column 4, line 28; figure * | 11,12 | |
| | ---       -/- | | |

The present search report has been drawn up for all claims

| Place of search | Date of completion of the search | Examiner |
|---|---|---|
| THE HAGUE | 19-01-1990 | BOETS A.F.J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................
& : member of the same patent family, corresponding document

EPO FORM 1503 03.82 (P0401)

**European Patent Office**

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | GB-A-1 040 485 (LICENTIA) --- | | |
| A | US-A-3 937 028 (ALAIS) --- | | |
| A | US-A-4 253 515 (SWIATOSZ) --- | | |
| A | DE-A-2 004 790 (SIEMENS) ----- | | |
| | | | TECHNICAL FIELDS SEARCHED (Int. Cl.5) |

The present search report has been drawn up for all claims

| Place of search | Date of completion of the search | Examiner |
|---|---|---|
| THE HAGUE | 19-01-1990 | BOETS A.F.J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)